# EUROPEAN PATENT SPECIFICATION

(11) **EP 2 479 912 B1**
(45) Date of publication and mention of the grant of the patent: **16.07.2014**
(21) Application number: 10816576.2
(22) Date of filing: 23.03.2010
(51) Int. Cl.: H03M 13/29, H03M 13/00, H04L 1/00

(54) **METHOD AND DEVICE FOR RATE MATCHING OR RATE DE-MATCHING**
VERFAHREN UND VORRICHTUNG ZUR FREQUENZANPASSUNG UND ZU DEREN AUFHEBUNG
PROCÉDÉ ET DISPOSITIF D'ADAPTATION DE DÉBIT OU DE DÉSADAPTATION DE DÉBIT

(30) Priority: 15.09.2009 CN 200910177535
(43) Date of publication of application: 25.07.2012
(73) Proprietor: ZTE Corporation, Shenzhen, Guangdong 518057 (CN)
(72) Inventor: LI, Bin, Shenzhen Guangdong 518057 (CN)
(74) Representative: Howson, Richard G.B.
(86) International application number: PCT/CN2010/071222
(87) International publication number: WO 2011/032372

(56) References cited:
- EP-A1- 1 826 937
- CN-A- 101 257 663
- CN-A- 101 388 751
- CN-A- 101 478 790
- US-A1- 2005 141 549
- US-A1- 2008 089 360
- US-A1- 2009 147 724

## Description

### TECHNICAL FIELD

The disclosure relates to the field of communication technologies, particularly to a method and device for rate matching or rate de-matching.

### BACKGROUND

At the end of 2004, the 3rd Generation Partnership Project (3GPP) proposes a 3G Long Term Evolution (LTE) plan that technical specifications thereof describe channel coding, multiplexing and interleaving, including Cyclic Redundancy Check (CRC) code calculation, code block division and CRC adding, channel coding, rate matching and code block cascading. The rate matching means applying slotting and repeating operations to coded data so as to satisfy a bit number that can be transmitted by a transmission physical channel.

The code block division is introduced here simply. The size of a transmission block is uncertain, the length range of coding length is scheduled by a Turbo coder and thus the code block after dividing the transmission block is requested to satisfy Table 5.1.3-3 in 3GPP 36.212 protocol by an interleaver used in an LTE system. Therefore, a Null is needed to be added to the front part of the first code block of the divided code block so as to satisfy the request of the interleaver.

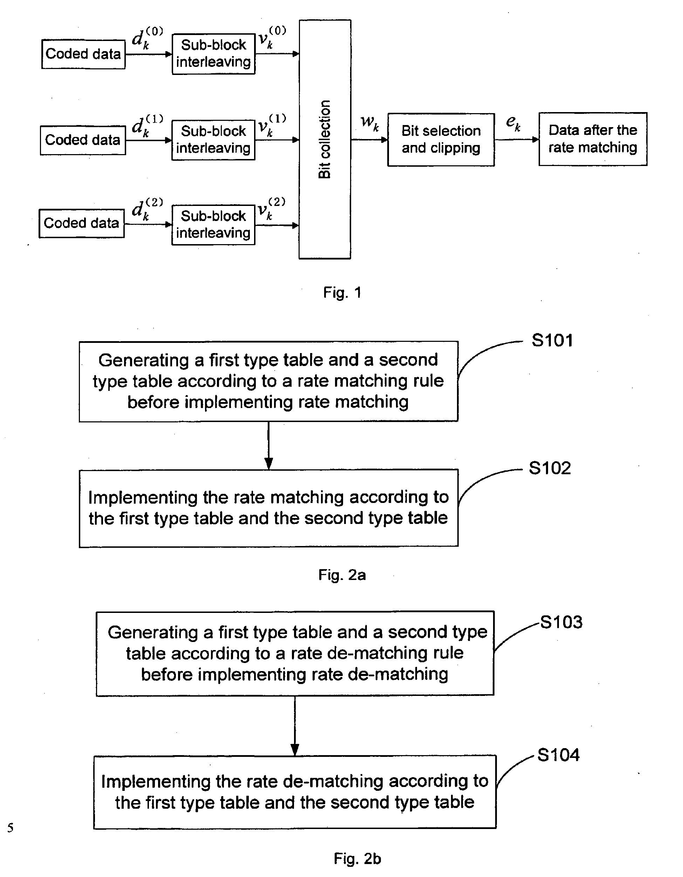

The rate matching is shown in Fig. 1, which comprises the following three steps: A: sub-block interleaving; B: bit collection; C: bit selection and clipping. In the sub-block interleaving step, when the length of a sub-block does not satisfy requests of a sub-block interleaver, Nulls are needed to be added again to the front of the sub-block. The bit collection aims at data after sub-block interleaving; three paths of data exists after coding and sub-block interleaving is applied to each path; in the bit collection, the first path of data after sub-block interleaving is arranged at the front part, then the second and third paths of data are arranged alternatively. The bit collection and clipping means removing all the introduced Nulls at the front part, thus locations of Nulls are determined and then the Nulls are removed while slotting or repeating.

Clearly, a large amount of movement of data is needed in realization process based on the rate matching algorithm, and the locations of Nulls are needed to be recorded so as to remove those Nulls in the rate matching process.

A rate de-matching process is corresponding to the rate matching process at a receiving terminal and it will not be described here again.

According to the process scheduled in the protocol, the data is reordered in step A and step B, which means arranging the second and third path of coding results alternatively. Therefore, space resources are waste in realization and time consumption is increased thus leading to low execution efficiency. And in step C, data is extracted from different locations and the locations of the Nulls should be excluded. Thus, the locations of the Nulls are recorded in step A, as the following steps in traditional realization method:
a: Calculating the number of Nulls added to a transmission block in code block division firstly and calculating the locations of the Nulls in sub-block interleaving.
b: Recording the locations of the Nulls in the sub-block interleaving.
c: Removing all the locations of the Nulls in bit selection and clipping.

A large storage space and a long processing time are needed when adopting the above mentioned steps. Obviously, this is a fatal defect to a system having a higher request on real-time performance, and the power consumption of products is too large.

US2005141549 (A1) discloses a method for adapting the data transfer rate of a data flow in a communication device according to which: the data flow can be subdivided into at least one data block containing transmission bits to be transmitted; the transmission bits are formed by a coding process from information-carrying input bits; transmission bits determined from a data block of the data flow are removed (punctured) in order to adapt the data transfer rate; a puncturing pattern stipulates which transmission bits are to be removed, and; the puncturing pattern is constructed in such a manner that transmission bits are preferably removed that, during the coding process, depend on few input bits. The present invention also relates to a corresponding

### SUMMARY

The technical problem to be solved by the disclosure is to provide a simple and easily realized method and device for rate matching and rate de-matching, for satisfying processing requests of a real-time system and solving problems of long processing time for rate matching and rate de-matching in an existing art.

To solve the problems above, the disclosure discloses methods and devices for rate matching and rate de-matching according to the claims.

The disclosure accomplishes such operations in need of moving large data amount as sub-block interleaving and so on before a system operates formally, and when the system is operated, corresponding table location is searched according to real-time parameters, the location in which data ought to be stored is read from the table location, data is stored (in rate matching) and read (in rate de-matching) according to the data locations indicated in the tables. With the disclosure, processing time of the system is saved, the calculation amount of the system is reduced, power consumption of products is reduced and processing requirements of the real-time system are fulfilled.

### BRIEF DESCRIPTION OF THE DRAWINGS

Fig. 1 shows a flowchart of rate matching processing in an existing art;
Fig. 2a shows a flowchart of a method for rate matching of embodiment 1 according to the disclosure;
Fig. 2b shows a flowchart of a method for rate de-matching of embodiment 1 according to the disclosure;
Fig. 3 shows a flowchart of rate matching of embodiment 2 according to the disclosure;
Fig. 4a shows a structural diagram of a device for rate matching of embodiment 3 according to the disclosure;
Fig. 4b shows a structural diagram of a device for rate de-matching of embodiment 3 according to the disclosure;
Fig. 5a shows a structural diagram of a device for rate matching of embodiment 4 according to the disclosure;
Fig. 5b shows a structural diagram of a device for rate de-matching of embodiment 4 according to the disclosure; and
Fig. 6 shows a diagram of implementing rate matching through a first type table of embodiment 5 according to the disclosure.

### DETAILED DESCRIPTION

To solve problems of long processing time in rate matching and rate de-matching in an existing art, the disclosure discloses a method and device for rate matching and rate de-matching. The disclosure is described below in detail with reference to the drawings and embodiments. And the specifically described embodiments are used for explaining the disclosure only, not limiting the disclosure.

According to traditional rate matching algorithm, the main calculation amount in the rate matching and rate de-matching caused by: location conversion in interleaving and Null location skipping in bit selection and clipping; the Null location is changed in interleaving and locations of Nulls are searched in bit combining and slotting, which makes the method more difficult.

The disclosure optimizes rate matching and rate de-matching through a searching table.

The size of a code block after code block division satisfies requests of Table 5.1.3-3 in 3GPP protocol 36.212; all the possibilities of data size are considered. Before operating a system, calculating Null locations of all these code blocks, traversing possibilities of each kind of code block and generating a needed table based on a traversing result. And when a system is operated, the locations for storing or reading of data after the rate matching or rate de-matching are obtained by reading different tables according to different parameters.

Combined with Fig. 2a, embodiment 1 of the disclosure discloses a method for rate matching, which comprises the following steps.

Step S101: before operating a system, a first type table and a second type table are generated according to a rate matching rule before implementing rate matching; the rate matching rule in this embodiment refers to a method for sub-block interleaving and bit collection, which is a method for performing sub-block interleaving and bit collection of the coded data. Data after bit collection is obtained after the sub-block interleaving and bit collection; data behind the Null location is moved forward in succession so as to cover the Null location and form data including no Null. The location of data after bit collection is stored in the first type table, namely, the first type table is generated. Furthermore, data in the first type table does not include any Null and thus a starting location k₀ in the rate matching and rate de-matching needs to be counted (the starting location in the rate matching process is same to the starting location in the rate de-matching process; thus, the disclosure represents the starting locations in the rate matching and rate de-matching with the k₀ uniformly). Code block sizes after the code block division are different; thus, different code block sizes are corresponding to different starting locations k₀ in the rate matching and rate de-matching. Furthermore, the corresponding relationship between different k₀ and a number of Nulls before the k₀ are needed to be counted. After counting, the second type table including the corresponding relationship between the starting location k₀ in the rate matching and rate de-matching and the number of Nulls before the k₀ is generated. The above step is implemented based on all possible code block sizes after the code block division, which means traversing every kind of code block, and the first type table and the second type table are generated according to a traversing result. Wherein, the first type table comprises several sub-tables; each kind of code block corresponds to a sub-table; in the rate matching process, it is only needed to searching a corresponding sub-table according to parameters corresponding to the rate matching, such as Redundancy Version (RV) parameters; furthermore, the k₀ and the number of Nulls before the k₀ corresponding to the code block size are searched in the second type table according to the RV parameters.

Step S102: the rate matching is implemented according to the first type table and the second type table, specifically comprises: when the system is operated, it is only needed to searching for the k₀ corresponding to the rate matching from the second type table according to specific parameters of the rate matching, such as RV values, to obtain the number of Nulls before the k₀; summating the k₀ and the number of Nulls before the k₀, to obtain the starting location of data in the first type table; then searching for the part corresponding to the rate matching from the first type table and storing data according to data location recorded in the first type table.

Combined with Fig. 2b, a method for rate de-matching corresponding to the above embodiment is similar to the method for rate matching including above steps, and the method for rate de-matching comprises the following steps.

Step S103, similar to step S101: a first type table and a second type table are generated according to a rate de-matching rule before implementing rate de-matching. Wherein methods of generating the first type table and the second type table, and contents of the first type table and the second type table are the same to the one described in step S101 and will not be described in detail again.

Step S104: the rate de-matching is implementetd according to the first type table and the second type table, specifically comprises: when a system is operated, according to specific parameters of the rate de-matching, such as RV values, it is only needed to searching for the corresponding sub-table from the first type table and searching for the k₀ corresponding to the rate de-matching from the second type table, to obtain a number of Nulls before the k₀; summating the k₀ and the number of Nulls before the k₀, to obtain the starting location of data in the first type table; then searching for the part corresponding to the rate de-matching from the first type table and reading data according to data location recorded in the first type table.

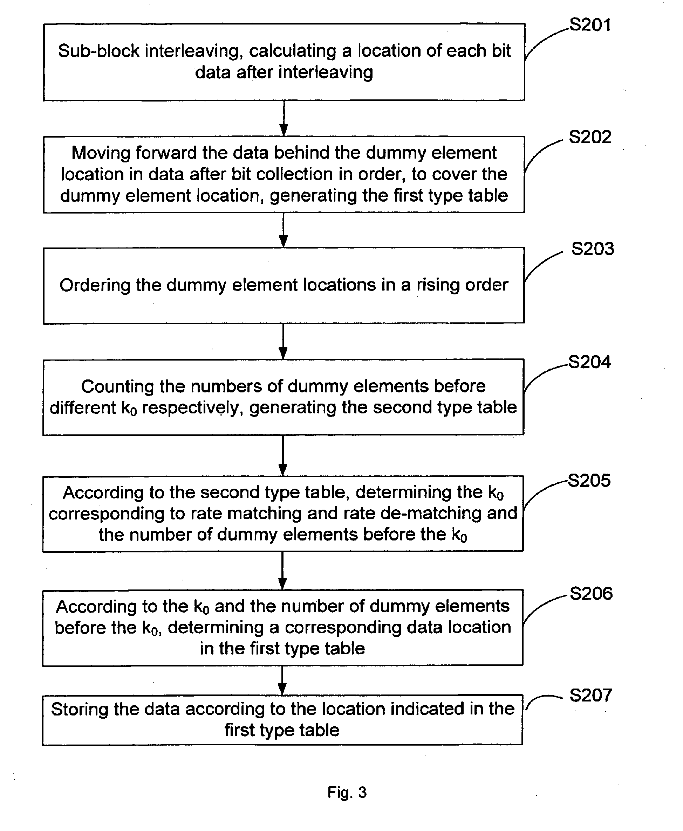

Fig. 3 is a flowchart of a method for rate matching of embodiment 2 according to the disclosure, which comprises the following steps.

Firstly, before operating a system, namely before implementing the rate matching by the system, all code blocks with different sizes are traversed and a first type table and a second type table are generated, specifically comprises the following steps.

Step S201: applying sub-block interleaving to coded data according to a rate matching rule, and calculating a location of each bit after interleaving according to a sub-block interleaving rule or method.

Step S202: bit collection is performed to the data, all Nulls in data after the bit collection are removed and data behind the Null locations are moved forward in succession to complement the Null locations; through the above steps, a first type table data including no Null is formed; the data locations of the first type table data are stored in the first type table and thus the first type table is generated.

Step S203: after generating the first type table, Null locations are ordered in a rising order; and this step aims at counting the number of Nulls before the k₀ conveniently.

Step S204: the number of Nulls before different k₀ are counted respectively; the second type table is generated according to the corresponding relationship between the k₀ and the number of Nulls before the k₀.

When a system is operated, in a specific rate matching operation, it comprises the following steps.

Step S205: according to parameters of the rate matching, such as RV values, the k₀ and the number of Nulls corresponding to the rate matching are searched from the second type table;

Step S206: according to searched the k₀ and the number of Nulls before the k₀, the k₀ and the number of Nulls before the k₀ are summated to obtain the starting location of data in the first type table (which means searching for the location corresponding to the rate matching from the first type table). The starting location of data of this embodiment in the first type table refers to the starting location of data storage in the rate matching.

Step S207: the location of each bit after the rate matching is stored in the first type table; thus, the data is stored according to data locations indicated in the first type table.

A method for rate de-matching corresponding to the above embodiment is similar to the method for rate matching including above steps, and the method for rate de-matching comprises: a first type table and a second type table are generated according to a rate de-matching rule before implementing the rate de-matching; wherein methods of generating the first type table and the second type table, and contents of the first type table and the second type table are the same to the one described in above steps. Furthermore, the step of searching for the location corresponding to the rate de-matching from the first type table is also the same to the second type table. And the only difference is: in step S207, the data is read according to data locations recorded in the first type table.

The step of generating the first type table and the second type table is set before the step of operating the system based on the above method; thus, it is only needed to searching for the corresponding first type table and the second type table according to specific parameters when system is operated, to obtain the storage location of data and store or read data according to data locations indicated in tables. The operating time of the rate matching or rate de-matching is shortened greatly; and real-time performance of system is improved.

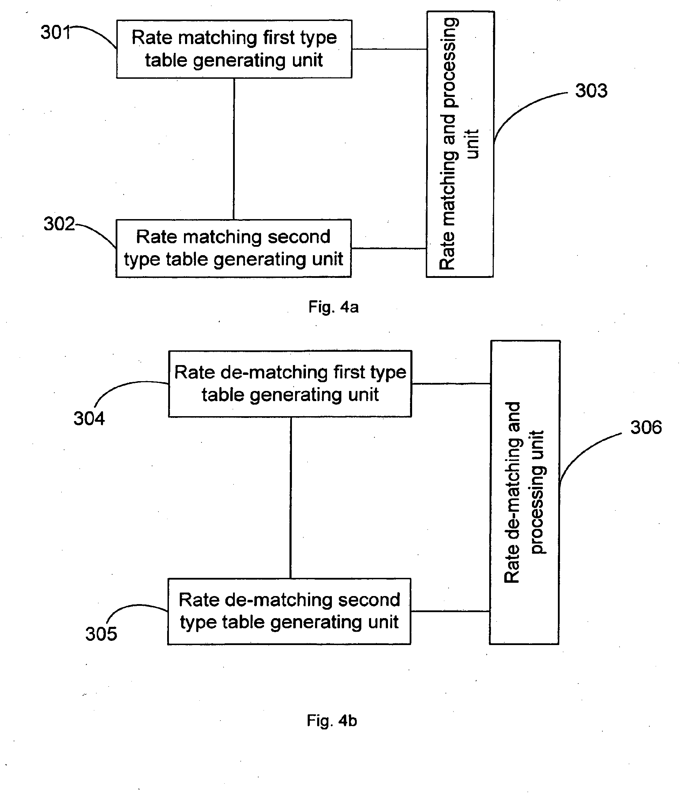

Fig. 4a is a structural diagram of a device for rate matching of embodiment 3 according to the disclosure. The device for rate matching comprises the following units based on Fig. 4a:
a rate matching first type table generating unit 301, configured to generate a first type table according to a rate matching rule before implementing rate matching; wherein the first type table comprises data locations of data after bit collection; the data after the bit collection comprises: data formed by data behind a Null location moving forward in succession, after the bit collection, to cover the Null location;
a rate matching second type table generating unit 302, configured to generate a second type table according to a rate matching rule before implementing rate matching; wherein the second type table comprises corresponding relationship between a starting location k₀ in rate matching and rate de-matching and a number of Nulls before the k₀; and
a rate matching and processing unit 303, configured to implement the rate matching according to the first type table generated by the rate matching first type table generating unit 301 and the second type table generated by the rate matching second type table generating unit 302, specifically comprises: according to parameters of the rate matching, such as RV values, search for the k₀ corresponding to the rate matching from the second type table generated by the rate matching second type table generating unit 302 and obtain a number of Nulls before the k₀; summate the k₀ and the number of Nulls before the k₀, obtain the starting location of data in the first type table; search for a storage location of data in the rate matching from the first type table and store the data according to data locations indicated in the first type table.

A device for rate de-matching corresponding to the above embodiment is shown in structural diagram Fig. 4b, which comprises:
a rate de-matching first type table generating unit 304, configured to generate a first type table according to a rate de-matching rule before implementing rate de-matching; wherein the first type table comprises data locations of data after bit collection; the data after the bit collection comprises: data formed by data behind a Null location moving forward in succession, after the bit collection, to cover the Null location;
a rate de-matching second type table generating unit 305, configured to generate a second type table according to a rate de-matching rule before implementing rate de-matching; wherein the second type table comprises corresponding relationship between a starting location k₀ in rate matching and rate de-matching and a number of Nulls before the k₀; and
a rate de-matching and processing unit 306, configured to implement the rate de-matching according to the first type table generated by the rate de-matching first type table generating unit 304 and the second type table generated by the rate de-matching second type table generating unit 305, specifically comprises: according to parameters of the rate de-matching, such as RV values, search for the k₀ corresponding to the rate de-matching from the second type table generated by the rate de-matching second type table generating unit 305 and obtain a number of Nulls before the k₀; summate the k₀ and the number of Nulls before the k₀, obtain the starting location of data in the first type table; search for a storage location of data in the rate de-matching from the first type table and read the data according to data locations indicated in the first type table.

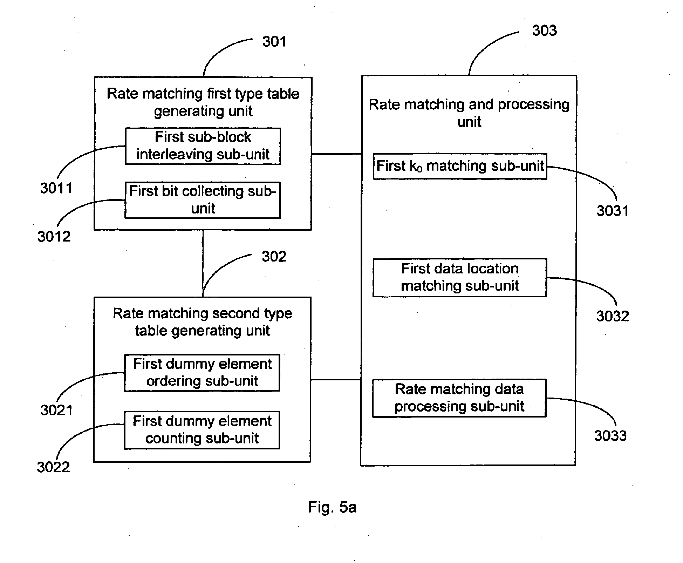

Fig. 5a is a structural diagram of a device for rate matching of embodiment 4 according to the disclosure. The device for rate matching comprises the following units based on Fig. 5a: a rate matching first type table generating unit 301, a rate matching second type table generating unit 302 and a rate matching and processing unit 303.

The rate matching first type table generating unit 301 further comprises a first sub-block interleaving sub-unit 3011 and a first bit collecting sub-unit 3012. The first sub-block interleaving sub-unit 3011 is configured to calculate a location of each bit data after interleaving in a sub-block interleaving process; and the first bit collecting sub-unit 3012 is configured to remove all Nulls in data after bit collection, make data behind Null location move forward in succession to cover the Null location and generate the first type table.

The rate matching second type table generating unit 302 further comprises a first Null ordering sub-unit 3021 and a first Null counting sub-unit 3022. The first Null ordering sub-unit 3021 is configured to order the Null locations in a rising order; and the first Null counting sub-unit 3022 is configured to traverse all the k₀, count the number of Nulls before different k₀ respectively, and generate the second type table.

The rate matching and processing unit 303 further comprises a first k₀ matching sub-unit 3031, a first data location matching sub-unit 3032 and a rate matching data processing sub-unit 3033. The first k₀ matching sub-unit 3031 is configured to determine the k₀ corresponding to the rate matching and the number of Nulls before the k₀ according to parameters of the rate matching and in conjunction with the second type table; the first data location matching sub-unit 3032 is configured to determine, in the first type table, the corresponding data location according to the k₀ and the number of Nulls before the k₀; and the rate matching data processing sub-unit 3033 is configured to store the data according to the data location indicated in the first type table.

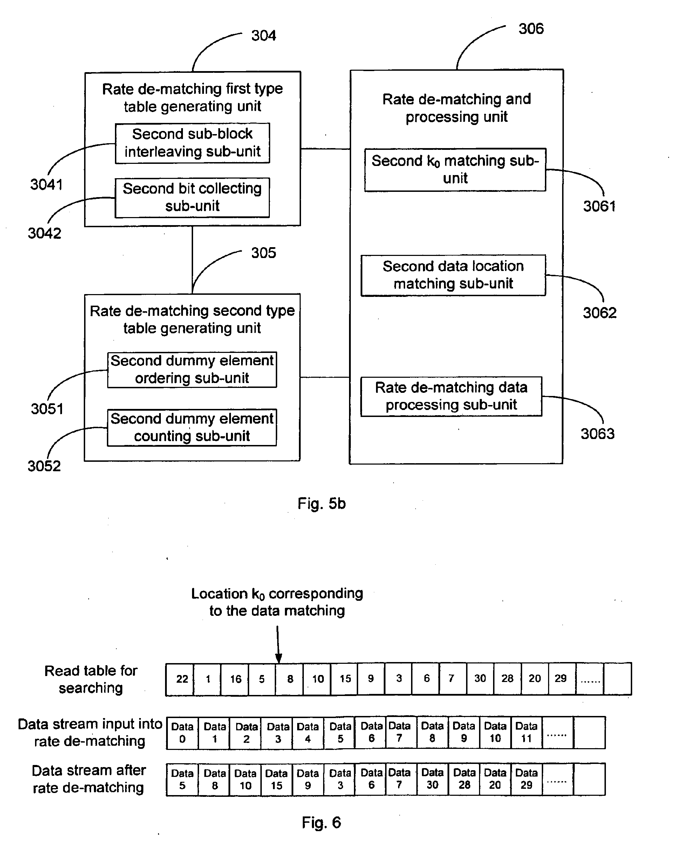

Combined with Fig. 5b, a device for rate de-matching corresponding to the embodiment comprises: a rate de-matching first type table generating unit 304, a rate de-matching second type table generating unit 305 and a rate de-matching and processing unit 306. The rate de-matching first type table generating unit 304 further comprises a second sub-block interleaving sub-unit 3041 and a second bit collecting sub-unit 3042. The rate de-matching second type table generating unit 305 further comprises a second Null ordering sub-unit 3051 and a second Null counting sub-unit 3052. The rate de-matching first type table generating unit 304, the second sub-block interleaving sub-unit 3041, the second bit collecting sub-unit 3042, the rate de-matching second type table generating unit 305, the second Null ordering sub-unit 3051 and the second Null counting sub-unit 3052 are the same in structural functions to the rate matching first type table generating unit 301, the first sub-block interleaving sub-unit 3011, the first bit collecting sub-unit 3012, the rate matching second type table generating unit 302, the first Null ordering sub-unit 3021 and the first Null counting sub-unit 3022 comprised in the device for rate matching of the embodiment; and the only difference is that the first type table and the second type table are generated according to a rate de-matching rule. Thus, their functions will not be described in detail again.

The rate de-matching and processing unit 306 comprises a second k₀ matching sub-unit 3061, a second data location matching sub-unit 3062 and a rate de-matching data processing sub-unit 3063. The second k₀ matching sub-unit 3061 and the second data location matching sub-unit 3062 are the same in structural functions to the first k₀ matching sub-unit 3031 and the first data location matching sub-unit 3032 comprised in the device for rate matching; and the differences are as follows: the k₀ corresponding to the rate de-matching is determined according to parameters of rate de-matching, and the corresponding data location is determined in the first type table, and other functions will not be described in detail again. The rate de-matching data processing sub-unit 3063 is configured to read data according to data locations indicated in the first type table.

Fig. 6 is a diagram of implementing rate matching through a first type table of embodiment 5 of the disclosure and the diagram here is just for illustrating. The uppermost table is the obtained first type table corresponding to the rate matching and the arrow represents the k₀ location corresponding to the rate matching. Owing to the limitation of space, the embodiment just shows the part of the first type table corresponding to the rate matching; actually, the first type table comprises data locations corresponding to all code block sizes; the middle table shows data stream input in the rate de-matching; and the downmost table shows data stream after the rate de-matching.

The second type table is used in the location calculation of the k₀ in searching table; according to algorithm requests, the k₀ comprises the Null location in calculation and the Nulls are arranged at the first N_{D} (number of Nulls added by the interleaver) elements (preferably row) of interleaving matrix; thus, it is needed to adding number of Nulls before the corresponding k₀ when calculating the location of the k₀ in searching table. The starting location of the rate matching in the first type table is location of data 5 (result obtained by summating the k₀ and number of Nulls before the k₀) through calculating.

As shown in the uppermost table of Fig. 6, the location of data after the rate matching is stored in the first type table; 5, 8, 10, 15, 9, 3, 6, 7, 30 28, 20, 29 ...... are extracted out from data stream needing rate matching according to locations indicated in current rate matching table, and then stored in data stream locations after the rate matching in order, as follows: Data5, Data8, Data10, Data15, Data9, Data3, Data6, Data7, Data30, Data28, Data20, Data29......, as shown in the downmost table in Fig. 6.

As for rate de-matching corresponding to the rate matching, the generated first type table and the second type table are the same to the above embodiment. Furthermore, the code block sizes corresponding to the rate matching and rate de-matching are the same, and the k₀ are the same, which means the starting location of the rate matching and rate de-matching are the same. Therefore, the starting location of the rate de-matching in the first type table is location of data 5 (result obtained by summating the k₀ and number of Nulls before the k₀) through calculating. Data5, Data8, Data10, Data15, Data9, Data3, Data6, Data7, Data30, Data28, Data20, Data29...... are read in order according to locations indicated in the first type table. The searching table can be used after de-repeating when de-repeating is needed in rate de-matching.

Based on above embodiment, the disclosure accomplishes such operations in need of moving large data amount as sub-block interleaving and so on before a system operates formally, and when the system is operated, corresponding table location is searched according to real-time parameters, the location in which data ought to be stored is read from the table location, data is stored (in rate matching) and read (in rate de-matching) according to the data locations indicated in the tables. With the disclosure, processing time of the system is saved, the calculation amount of the system is reduced, power consumption of products is reduced and processing requirements of the real-time system are fulfilled.

## Claims

1. A method for rate matching comprising:
generating a first type table and a second type table according to a rate matching rule before implementing rate matching (S101); wherein the first type table comprises data locations, the data locations comprise locations of data formed by moving forward data behind the location of Nulls or consecutive bits of data between the two Null segments, sequentially, after the bit collection, to cover the location of Nulls; and the second type table comprises corresponding relationship between a starting location k₀ for rate matching and rate de-matching and a number of Nulls before the k0, the starting location k₀ is a location of a first data element after the Nulls that is moved forward ; and
implementing the rate matching according to the first type table and the second type table (S102); wherein
the step of generating the second type table comprises:
ordering the locations of Nulls in a rising order (S203); and
traversing all the k₀, counting the number of Nulls before different k₀ respectively, and generating the second type table according to the corresponding relationship between the different k₀ and the number of Nulls before the different k₀ (S204).

2. The method for rate matching according to claim 1, wherein the step of implementing the rate matching according to the first type table and the second type table comprises:
determining the k₀ corresponding to the rate matching and the number of Nulls before the k₀ according to parameters of the rate matching and in conjunction with the second type table (S205);
determining, in the first type table, the corresponding data location according to the k₀ and the number of Nulls before the k₀ (S206); and
storing the data according to the data location indicated in the first type table (S207).

3. A method for rate de-matching comprising:
generating a first type table and a second type table according to a rate de-matching rule before implementing rate de-matching (S101); wherein the first type table comprises data locations, the data locations comprise locations of data formed by moving forward data behind the location of Nulls or consecutive bits of data between the two Null segments, sequentially, after the bit collection, to cover the location of Nulls; and the second type table comprises corresponding relationship between a starting location k₀ for rate matching and rate de-matching and a number of Nulls before the k₀, the starting location k₀ is a location of a first data element after the Nulls that is moved forward; and
implementing the rate de-matching according to the first type table and the second type table (S102); wherein
wherein the step of generating the second type table comprises:
ordering the locations of Nulls in a rising order (S203); and
traversing all the k₀, counting the number of Nulls before different k₀ respectively, and generating the second type table according to the corresponding relationship between the different k₀ and the number of Nulls before the different k₀ (S204).

4. The method for rate de-matching according to claim 3, wherein the step of implementing the rate de-matching according to the first type table and the second type table comprises:
according to parameters of the rate de-matching and in conjunction with the second type table, determining the k₀ corresponding to the rate de-matching and the number of Nulls before the k₀ (S205);
determining, in the first type table, the corresponding data location according to the k₀ and the number of Nulls before the k₀ (S206); and
reading the data according to the data location indicated in the first type table (S207).

5. A device for rate matching comprising:
a rate matching first type table generating unit (301), configured to generate a first type table according to a rate matching rule before implementing rate matching; wherein the first type table comprises data locations, the data locations comprise locations of data formed by moving forward data behind the location of Nulls or consecutive bits of data between the two Null segments, sequentially, after the bit collection, to cover the location of Nulls after the bit collection;
a rate matching second type table generating unit (302), configured to generate a second type table according to a rate matching rule before implementing the rate matching; wherein the second type table comprises corresponding relationship between a starting location k₀ for the rate matching and rate de-matching and a number of Nulls before the k₀, the starting location k₀ is a location of a first data element after the Nulls that is moved forward; and
a rate matching and processing unit (303), configured to implement the rate matching according to the first type table and the second type table; wherein
the rate matching second type table generating unit (302) comprises: a first Null ordering sub-unit (3021), configured to order the locations of Nulls locations in a rising order; and a first Null counting sub-unit (3022), configured to traversé all the k₀, count the number of Nulls before different k₀ respectively, and generate the second type table according to the corresponding relationship between the different k₀ and the number of Nulls before the different k₀.

6. The device for rate matching according to claim 5, wherein the rate matching and processing unit (303) comprises: a first k₀ matching sub-unit (3031), configured to determine the k₀ corresponding to the rate matching and the number of Nulls before the k₀ according to parameters of the rate matching and in conjunction with the second type table; a first data location matching sub-unit (3032), configured to determine, in the first type table, the corresponding data location according to the k₀ and the number of Nulls before the k₀; and a rate matching data processing sub-unit (3033), configured to store the data according to the data location indicated in the first type table.

7. A device for rate de-matching comprising:
a rate de-matching first type table generating unit (304), configured to generate a first type table according to a rate de-matching rule before implementing rate de-matching; wherein the first type table comprises data locations, the data locations comprise locations of data formed by moving forward the location of Nulls or consecutive bits of data between the two Null segments, sequentially, after the bit collection, to cover the location of Nulls;
a rate de-matching second type table generating unit (305), configured to generate a second type table according to a rate de-matching rule before implementing the rate de-matching; wherein the second type table comprises corresponding relationship between a starting location k₀ in the rate matching and rate de-matching and a number of Nulls before the k₀, the starting location k₀ is a location of a first data element after the Nulls that is moved forward; and
a rate de-matching and processing unit (306), configured to implement the rate de-matching according to the first type table and the second type table; wherein
the rate de-matching second type table generating unit (305) comprises: a second Null ordering sub-unit (3051), configured to order the locations of Nulls in a rising order; and a second Null counting sub-unit (3052), configured to traverse all the k₀, count the number of Nulls before different k₀ respectively, and generate the second type table according to the corresponding relationship between the different k₀ and the number of Nulls before the different k₀.

8. The device for rate de-matching according to claim 7, wherein
the rate de-matching and processing unit (306) comprises: a second k₀ matching sub-unit (3061), configured to determine the k₀ corresponding to the rate de-matching and the number of Nulls before the k₀ according to parameters of the rate matching and in conjunction with the second type table; a second data location matching sub-unit (3062), configured to determine, in the first type table, the corresponding data location according to the k₀ and the number of Nulls before the k₀; and a rate de-matching data processing sub-unit (3063), configured to read the data according to the data location indicated in the first type table.

## Patentansprüche

1. Verfahren zur Ratenanpassung, das umfasst:
Erzeugen einer Tabelle eines ersten Typs und einer Tabelle eines zweiten Typs gemäß einer Ratenanpassungsregel vor dem Implementieren der Ratenanpassung (S101); wobei die Tabelle des ersten Typs Datenstellen aufweist, wobei die Datenstellen Stellen von Daten aufweisen, die durch Vorwärtsbewegen von Daten hinter der Stelle von Nullen oder konsekutiven Bits von Daten zwischen den beiden Nullsegmenten, nacheinander, nach der Biterfassung gebildet werden, um die Stelle von Nullen zu abzudecken; und wobei die Tabelle des zweiten Typs eine korrespondierende Beziehung zwischen einer Startstelle k₀ zur Ratenanpassung und zum Rückgängigmachen der Ratenanpassung und einer Anzahl von Nullen vor k₀ aufweist, wobei die Startstelle k₀ eine Stelle eines ersten Datenelements nach den Nullen ist, das vorwärtsbewegt wird; und
Implementieren der Ratenanpassung gemäß der Tabelle des ersten Typs und der Tabelle des zweiten Typs (S 102); wobei
der Schritt des Erzeugens der Tabelle des zweiten Typs umfasst:
Anordnen der Stellen von Nullen in aufsteigender Ordnung (S203); und
Durchlaufen aller k₀, Zählen der Anzahl von Nullen jeweils vor unterschiedlichen k₀, und Erzeugen der Tabelle des zweiten Typs gemäß der korrespondierenden Beziehung zwischen den unterschiedlichen k₀ und der Anzahl von Nullen vor den unterschiedlichen k₀ (S204).

2. Verfahren zur Ratenanpassung gemäß Anspruch 1, wobei der Schritt des Implementierens der Ratenanpassung gemäß der Tabelle des ersten Typs und der Tabelle des zweiten Typs umfasst:
Ermitteln von k₀ entsprechend der Ratenanpassung und der Anzahl von Nullen vor k₀ gemäß Parametern der Ratenanpassung und in Zusammenhang mit der Tabelle des zweiten Typs (S205);
Ermitteln, in der Tabelle des ersten Typs, der korrespondierenden Datenstelle gemäß k₀ und der Anzahl von Nullen vor k₀ (S206); und
Speichern der Daten gemäß der in der Tabelle des ersten Typs angegebenen Datenstelle (S207).

3. Verfahren zum Rückgängigmachen der Ratenanpassung, das umfasst:
Erzeugen einer Tabelle des ersten Typs und einer Tabelle des zweiten Typs gemäß einer Regel zum Rückgängigmachen der Ratenanpassung vor dem Implementieren des Rückgängigmachens der Ratenanpassung (S101); wobei die Tabelle des ersten Typs Datenstellen aufweist, wobei die Datenstellen Stellen von Daten aufweisen, die durch Vorwärtsbewegen von Daten hinter der Stelle von Nullen oder konsekutiven Bits von Daten zwischen den beiden Nullsegmenten, nacheinander, nach der Biterfassung gebildet werden, um die Stelle von Nullen zu abzudecken; und wobei die Tabelle des zweiten Typs eine korrespondierende Beziehung zwischen einer Startstelle k₀ zur Ratenanpassung und zum Rückgängigmachen der Ratenanpassung und einer Anzahl von Nullen vor k₀ aufweist, wobei die Startstelle k₀ eine Stelle eines ersten Datenelements nach den Nullen ist, das vorwärtsbewegt wird; und
Implementieren des Rückgängigmachens der Ratenanpassung gemäß der Tabelle des ersten Typs und der Tabelle des zweiten Typs (S 102); wobei
der Schritt des Erzeugens der Tabelle des zweiten Typs umfasst:
Anordnen der Stellen von Nullen in aufsteigender Ordnung (S203); und
Durchlaufen aller k₀, Zählen der Anzahl von Nullen jeweils vor unterschiedlichen k₀, und Erzeugen der Tabelle des zweiten Typs gemäß der korrespondierenden Beziehung zwischen den unterschiedlichen k₀ und der Anzahl von Nullen vor den unterschiedlichen k₀ (S204).

4. Verfahren zum Rückgängigmachen der Ratenanpassung gemäß Anspruch 3, wobei der Schritt des Implementierens des Rückgängigmachens der Ratenanpassung gemäß der Tabelle des ersten Typs und der Tabelle des zweiten Typs umfasst:
gemäß Parametern des Rückgängigmachens der Ratenanpassung und in Zusammenhang mit der Tabelle des zweiten Typs, Ermitteln von k₀ entsprechend des Rückgängigmachens der Ratenanpassung und der Anzahl von Nullen vor k₀ (S205);
Ermitteln, in der Tabelle des ersten Typs, der korrespondierenden Datenstelle gemäß k₀ und der Anzahl von Nullen vor k₀ (S206); und
Lesen der Daten gemäß der in der Tabelle des ersten Typs angegebenen Datenstelle (S207).

5. Vorrichtung zur Ratenanpassung, die aufweist:
eine Einheit (301) zum Erzeugen einer Ratenanpassungstabelle des ersten Typs, die dazu konfiguriert ist, eine Tabelle des ersten Typs gemäß einer Ratenanpassungsregel vor dem Implementieren der Ratenanpassung zu erzeugen; wobei die Tabelle des ersten Typs Datenstellen aufweist, wobei die Datenstellen Stellen von Daten aufweisen, die durch Vorwärtsbewegen von Daten hinter der Stelle von Nullen oder konsekutiver Bits von Daten zwischen den beiden Nullsegmenten, nacheinander, nach der Biterfassung gebildet werden, um die Stelle von Nullen nach der Biterfassung zu abzudecken;
eine Einheit (302) zum Erzeugen einer Ratenanpassungstabelle des zweiten Typs, die dazu konfiguriert ist, eine Tabelle des zweiten Typs gemäß einer Ratenanpassungsregel vor dem Implementieren der Ratenanpassung zu erzeugen; wobei die Tabelle des zweiten Typs eine korrespondierende Beziehung zwischen einer Startstelle k₀ zur Ratenanpassung und zum Rückgängigmachen der Ratenanpassung und einer Anzahl von Nullen vor k₀ aufweist, wobei die Startstelle k₀ eine Stelle eines ersten Datenelements nach den Nullen ist, das vorwärtsbewegt wird; und
eine Ratenanpassungs- und Verarbeitungseinheit (303), die dazu konfiguriert ist, die Ratenanpassung gemäß der Tabelle des ersten Typs und der Tabelle des zweiten Typs zu implementieren; wobei
die Einheit (302) zum Erzeugen einer Ratenanpassungstabelle des zweiten Typs aufweist: eine erste Nullanordnungs-Untereinheit (3021), die dazu konfiguriert ist, die Stellen von Nullstellen in aufsteigender Ordnung anzuordnen; und eine erste Nullzählungs-Untereinheit (3022), die dazu konfiguriert ist, alle k₀ zu durchlaufen, die Anzahl von Nullen jeweils vor unterschiedlichen k₀ zu zählen, und die Tabelle des zweiten Typs gemäß der korrespondierenden Beziehung zwischen den unterschiedlichen k₀ und der Anzahl von Nullen vor den unterschiedlichen k₀ zu erzeugen.

6. Vorrichtung zur Ratenanpassung gemäß Anspruch 5, wobei die Ratenanpassungs- und Verarbeitungseinheit (303) aufweist: eine erste k₀ Anpassungs-Untereinheit (3031), die dazu konfiguriert ist, k₀ entsprechend der Ratenanpassung und der Anzahl von Nullen vor k₀ gemäß Parametern der Ratenanpassung und in Zusammenhang mit der Tabelle des zweiten Typs zu ermitteln; eine erste Datenstelle-Anpassungs-Untereinheit (3032), die dazu konfiguriert ist, in der Tabelle des ersten Typs die korrespondierende Datenstelle gemäß k₀ und der Anzahl von Nullen vor k₀ zu ermitteln; und eine Ratenanpassungs-Datenverarbeitungs-Untereinheit (3033), die dazu konfiguriert ist, die Daten gemäß der in der Tabelle des ersten Typs angegebenen Datenstelle zu speichern.

7. Vorrichtung zum Rückgängigmachen der Ratenanpassung, die aufweist:
eine Einheit (304) zum Erzeugen einer Tabelle des ersten Typs zum Rückgängigmachen der Ratenanpassung, die dazu konfiguriert ist, eine Tabelle des ersten Typs gemäß einer Regel zum Rückgängigmachen der Ratenanpassung vor dem Implementieren des Rückgängigmachens der Ratenanpassung zu erzeugen; wobei die Tabelle des ersten Typs Datenstellen aufweist, wobei die Datenstellen Stellen von Daten aufweisen, die durch Vorwärtsbewegen der Stelle von Nullen oder konsekutiver Bits von Daten zwischen den beiden Nullsegmenten, nacheinander, nach der Biterfassung gebildet werden, um die Stelle von Nullen abzudecken;
eine Einheit (305) zum Erzeugen einer Tabelle des zweiten Typs zum Rückgängigmachen der Ratenanpassung, die dazu konfiguriert ist, eine Tabelle des zweiten Typs gemäß einer Regel zum Rückgängigmachen der Ratenanpassung vor dem Implementieren des Rückgängigmachens der Ratenanpassung zu erzeugen; wobei die Tabelle des zweiten Typs eine korrespondierende Beziehung zwischen einer Startstelle k₀ zur Ratenanpassung und zum Rückgängigmachen der Ratenanpassung und einer Anzahl von Nullen vor k₀ aufweist, wobei die Startstelle k₀ eine Stelle eines ersten Datenelements nach den Nullen ist, das vorwärtsbewegt wird; und
eine Einheit zum Rückgängigmachen der Ratenanpassung und zum Verarbeiten (306), die dazu konfiguriert ist, das Rückgängigmachen der Ratenanpassung gemäß der Tabelle des ersten Typs und der Tabelle des zweiten Typs zu implementieren; wobei
die Einheit (305) zum Erzeugen einer Tabelle des zweiten Typs zum Rückgängigmachen der Ratenanpassung aufweist: eine zweite Nullanordnungs-Untereinheit (3051), die dazu konfiguriert ist, die Stellen von Nullen in aufsteigender Ordnung anzuordnen; und eine zweite Nullzählungs-Untereinheit (3052), die dazu konfiguriert ist, alle k₀ zu durchlaufen, die Anzahl von Nullen jeweils vor unterschiedlichen k₀ zu zählen, und die Tabelle des zweiten Typs gemäß der korrespondierenden Beziehung zwischen den unterschiedlichen k₀ und der Anzahl von Nullen vor den unterschiedlichen k₀ zu erzeugen.

8. Vorrichtung zum Rückgängigmachen der Ratenanpassung nach Anspruch 7, wobei
die Einheit zum Rückgängigmachen der Ratenanpassung und zum Verarbeiten (306) aufweist: eine zweite k0 Anpassungs-Untereinheit (3061), die dazu konfiguriert ist, k₀ entsprechend des Rückgängigmachens der Ratenanpassung und der Anzahl von Nullen vor k₀ gemäß Parametern der Ratenanpassung und in Zusammenhang mit der Tabelle des zweiten Typs zu ermitteln; eine zweite Datenstelle-Anpassungs-Untereinheit (3062), die dazu konfiguriert ist, in der Tabelle des ersten Typs die korrespondierende Datenstelle gemäß k₀ und der Anzahl von Nullen vor k₀ zu ermitteln; und eine Datenverarbeitungs-Untereinheit (3063) zum Rückgängigmachen der Ratenanpassung, die dazu konfiguriert ist, die Daten gemäß der in der Tabelle des ersten Typs angegebenen Datenstelle zu lesen.

## Revendications

1. Procédé pour l'adaptation de débit comprenant :
la génération d'une première table de type et d'une seconde table de type, selon une règle d'adaptation de débit, avant de mettre en oeuvre l'adaptation de débit (S101) ; dans lequel la première table de type comprend des emplacements de données, les emplacements de données comprennent des emplacements de données formées en faisant avancer des données derrière l'emplacement de caractères nuls ou de bits consécutifs de données entre les deux segments de caractères nuls, séquentiellement, après la collecte de bits, afin de couvrir l'emplacement de caractères nuls ; et la seconde table de type comprend une relation correspondante entre un emplacement de départ k₀ pour une adaptation et une désadaptation de type et un certain nombre de caractères nuls avant le k₀, l'emplacement de départ k₀ étant un emplacement d'un premier élément de données après le déplacement en avant des caractères nuls ; et
la mise en oeuvre de l'adaptation de débit selon la première table de type et la seconde table de type (S102) ; dans lequel
l'étape consistant à générer la seconde table de type comprend :
l'ordonnancement des emplacements de caractères nuls dans un ordre croissant (S203) ; et
la traversée de tous les k₀, en comptant le nombre de caractères nuls avant les différents k₀, respectivement et la génération de la seconde table de type selon la relation correspondante entre les différents k₀ et le nombre de caractères nuls avant les différents k₀ (S204).

2. Procédé d'adaptation de débit selon la revendication 1, dans lequel l'étape consistant à mettre en oeuvre l'adaptation de débit selon la première table de type et la seconde table de type comprend :
la détermination du k₀ correspondant à l'adaptation de débit et au nombre de caractères nuls avant le k₀, selon les paramètres de l'adaptation de débit et en combinaison avec la seconde table de type (S205) ;
la détermination, dans la première table de type, l'emplacement de données correspondante selon le k₀ et le nombre de caractères nuls avant le k₀ (S206) ; et
le stockage des données, selon l'emplacement de données indiqué dans la première table de type (S207).

3. Procédé de désadaptation de débit comprenant :
la génération d'une première table de type et d'une seconde table de type selon une règle de désadaptation de débit, avant de mettre en oeuvre la désadaptation de débit (S101) ; dans lequel la première table de type comprend des emplacements de données, les emplacements de données comprenant des emplacements de données formés par le déplacement en avant de données derrière l'emplacement de caractères nuls ou de bits de données consécutifs entre les deux segments de caractères nuls, séquentiellement, après la collecte de bits, pour couvrir l'emplacement de caractères nuls ; et la seconde table de type comprend une relation entre un emplacement de départ k₀ pour l'adaptation de débit et la désadaptation de débit et un certain nombre de caractères nuls avant le k₀, l'emplacement de départ k₀ est un emplacement d'un premier élément de données après les caractères nuls qui sont déplacés en avant ; et
la mise en oeuvre de la désadaptation de débit selon la première table de type et la seconde table de type (S102) ;
dans lequel l'étape de génération de la seconde table de type comprend :
l'ordonnancement des emplacements de caractères nuls dans l'ordre croissant (S203) ; et
la traversée de tous les k₀, en comptant le nombre de caractères nuls avant les différents k₀ respectivement, et la génération de la seconde table de type, selon la relation correspondante entre les différents k₀ et le nombre de caractères nuls avant les différents k₀ (S204).

4. Procédé de désadaptation de débit selon la revendication 3, dans lequel l'étape consistant à mettre en oeuvre la désadaptation de débit selon la première table de type et la seconde table de type comprend :
selon les paramètres de la désadaptation de type et en combinaison avec la seconde table de type, la détermination du k₀ correspondant à la désadaptation de type et au nombre de caractères nuls avant le k₀ (S205) ;
la détermination, dans la première table de type, de l'emplacement de données correspondant selon le k₀ et le nombre de caractères nuls avant le k₀ (S206), et
la lecture des données selon l'emplacement de données indiqué dans la première table de type (S207).

5. Dispositif d'adaptation de débit comprenant :
une unité de génération de la première table de type d'adaptation de débit (301) configurée pour générer une première table de type, selon une règle d'adaptation de débit avant de mettre en oeuvre l'adaptation de débit ;
dans lequel la première table de type comprend les emplacements de données, les emplacements de données comprennent des emplacements de données formés en faisant avancer des données derrière l'emplacement de caractères nuls ou de bits consécutifs de données entre les deux segments de caractères nuls, séquentiellement, après la collecte de bits, afin de couvrir l'emplacement de caractères nuls après la collecte de bits ;
une unité de génération d'une seconde table de type d'adaptation de débit (302) configurée afin de générer une seconde table de type, selon une règle d'adaptation de débit, avant de mettre en oeuvre l'adaptation de débit ; dans lequel la seconde table de type comprend une relation correspondante entre un emplacement de départ k₀ pour l'adaptation de débit et la désadaptation de débit et un certain nombre de caractères nuls avant le k₀, l'emplacement de départ k₀ étant un emplacement d'un premier élément de données après le déplacement en avant des caractères nuls ; et
une unité d'adaptation et de traitement de débit (303), configurée de façon à mettre en oeuvre l'adaptation de débit selon la première table de type et la seconde table de type ; dans laquelle
l'unité de génération de la seconde table de type d'adaptation de débit (302) comprend : une première sous-unité d'ordonnancement de caractères nuls (3021), configurée de façon à ordonner les emplacements de caractères nuls dans un ordre croissant ; et une première sous-unité de décompte de caractères nuls (3022), configurée de façon à traverser tous les k₀, à compter le nombre de caractères nuls avant différents k₀ respectivement, et générer la seconde table de type selon la relation correspondante entre les différents k₀ et le nombre de caractères nuls avant les différents k₀.

6. Dispositif d'adaptation de débit selon la revendication 5, dans lequel l'unité d'adaptation et de traitement de débit (303) comprend : une première sous-unité d'adaptation k₀ (3031), configurée de façon à déterminer le k₀ correspondant à l'adaptation de débit et au nombre de caractères nuls avant le k₀ selon des paramètres de l'adaptation de débit et en combinaison avec la seconde table de type ; une première sous-unité d'adaptation d'emplacement de données (3032), configurée de façon à déterminer, dans la première table de type, l'emplacement de données correspondantes selon le k₀, et le nombre de caractères nuls avant le k₀; et une sous-unité de traitement de données d'adaptation de débit (3033) configurée de façon à stocker les données selon l'emplacement de données indiqué dans la première table de type.

7. Dispositif de désadaptation de débit comprenant :
une unité de génération de première table de type de désadaptation de débit (304), configurée de façon à générer une première table de type, selon une règle de désadaptation de débit, avant de mettre en oeuvre la désadaptation de débit ; dans lequel la première table de débit comprend des emplacements de données, les emplacements de données comprennent des emplacements de données formés en faisant avancer l'emplacement de caractères nuls ou de bits consécutifs de données entre les deux segments de caractères nuls, séquentiellement, après la collecte de bits, afin de couvrir l'emplacement de caractères nuls ;
une unité de génération de seconde table de type de désadaptation de débit (305), configurée de façon à générer une seconde table de type, selon une règle de désadaptation de débit, avant de mettre en oeuvre la désadaptation de débit ; dans lequel la seconde table de type comprend une relation correspondante entre un emplacement de départ k₀ dans l'adaptation de débit et la désadaptation de débit et un certain nombre de caractères nuls avant le k₀, l'emplacement de départ k₀ étant un emplacement d'un premier élément de données après les caractères nuls qui sont avancés ; et
une unité de désadaptation et de traitement de débit (306), configurée de façon à mettre en oeuvre la désadaptation de débit selon la première table de type et la seconde table de type ; dans lequel
l'unité de génération de seconde table de type de désadaptation de débit (305) comprend : une seconde sous-unité d'ordonnancement de caractères nuls (3051), configurée de façon à ordonner les emplacements de caractères nuls dans un ordre croissant ; et une seconde sous-unité de décompte de caractères nuls (3052), configurée de façon à traverser tous les k₀, à compter le nombre de caractères nuls avant les différents k₀ respectivement et générer la seconde table de type selon la relation correspondante entre les différents k₀ et le nombre de caractères nuls avant les différents k₀ ; et une sous-unité de traitement de données de désadaptation de débit (3063), configurée de façon à lire les données selon l'emplacement de données indiqué dans la première table de type.

8. Dispositif de désadaptation de débit selon la revendication 7,
dans lequel l'unité de désadaptation de débit et de traitement de débit (306) comprend : une seconde sous-unité d'adaptation de k₀ (3061), configurée pour déterminer le k₀ correspondant à la désadaptation de débit et le nombre de caractères nuls avant le k₀ selon les paramètres d'adaptation de débit et en combinaison avec la seconde table de type ; une seconde sous-unité d'adaptation d'emplacement de données (3062) configurée pour déterminer, dans la première table de type, l'emplacement des données correspondante selon le k₀ et le nombre de caractères nuls avant le k₀, et une sous-unité de traitement de données de désadaptation de débit (3063), configurée de façon à lire les données selon l'emplacement de données indiqué dans la première table de type.
